# EUROPÄISCHE PATENTANMELDUNG

(11) **EP 3 734 863 A1**
(43) Veröffentlichungstag der Anmeldung: **04.11.2020**
(21) Anmeldenummer: 20160857.7
(22) Anmeldetag: 04.03.2020
(51) Int. Cl.: H04B 10/2507, H04B 10/50, H04B 10/63, H04B 10/66

(54) **ANORDNUNG ZUR DATENÜBERTRAGUNG**

(30) Priorität: 25.04.2019 AT 503742019
(71) Anmelder: AIT Austrian Institute of Technology GmbH, 1210 Wien (AT)
(72) Erfinder: SCHRENK, Bernhard, 2122 Ulrichskirchen (AT)
(74) Vertreter: Wildhack & Jellinek

(57) **Zusammenfassung**

Die Erfindung betrifft eine Anordnung (100) zur Datenübertragung umfassend einen Sender (1) und einen mit dem Sender (1) über einen optischen Kanal (3) verbundenen Empfänger (2),
- wobei der Sender (1) einen Senderlaser (13) und einen dem Senderlaser (13) nachgeschalteten senderseitigen Elektroabsorptionsmodulator (10) umfasst,
wobei der optische Ausgang (11) des senderseitigen Elektroabsorptionsmodulators (10) den Ausgang des Senders (1) bildet und an den optischen Kanal (3) angekoppelt ist, und
wobei der Sender (1) einen elektrischen Dateneingang aufweist, der an den elektrischen Modulationsanschluss (12) des senderseitigen Elektroabsorptionsmodulators (10) angeschlossen ist,

- wobei der Empfänger (2) einen Empfängerlaser (23) und einen dem Empfängerlaser (23) nachgeschalteten empfängerseitigen Elektroabsorptionsmodulator (20) umfasst,
wobei der optische Ausgang (21) des empfängerseitigen Elektroabsorptionsmodulators (20) den Eingang des Empfängers (2) bildet und an den optischen Kanal (3) angekoppelt ist, und
wobei der Empfänger (2) einen elektrischen Datenausgang aufweist, der an den elektrischen Modulationsanschluss (22) des empfängerseitigen Elektroabsorptionsmodulators (20) angeschlossen ist,

- wobei der Senderlaser (13) und der Empfängerlaser (23) durch Vorgabe einer physikalischen Größe, insbesondere durch Vorgabe des Laserstroms (I_{L}) oder der Lasertemperatur (Temp), verstimmbar sind,
- wobei eine senderseitige Steuereinheit (14) und eine empfängerseitige Steuereinheit (24) vorgesehen sind, die die jeweilige physikalische Größe zur Verstimmung des jeweiligen Lasers (13, 23) vorgeben,
- wobei die senderseitige Steuereinheit (14) und die empfängerseitige Steuereinheit (24) miteinander synchronisiert sind, und
- wobei die senderseitige Steuereinheit (14) und die empfängerseitige Steuereinheit (24) an ihrem Ausgang (15, 25) jeweils dasselbe Signal zur Festlegung der physikalischen Größe zur Festlegung der Laserfrequenz vorgeben.

## Beschreibung

Die Erfindung betrifft eine Anordnung zur Datenübertragung umfassend einen Sender und einen mit dem Sender über einen optischen Kanal verbundenen Empfänger gemäß Patentanspruch 1 sowie ein Verfahren zur Datenübertragung gemäß Patentanspruch 2.

Aus dem Stand der Technik sind Vorrichtungen zum Senden von Daten oder Signalen umfassend jeweils einen Laser und einen Elektroabsorptionsmodulator bekannt. Das vom Laser ausgesendete Licht wird dabei durch den Elektroabsorptionsmodulator abgeschwächt, sodass das Licht am Ausgang des Elektroabsorptionsmodulators moduliert vorliegt und über einen Lichtwellenleiter an einen Empfänger übertragen werden kann.

Um in einer derartigen Anordnung eine kohärente Detektion des übertragenen Signals zu ermöglichen, ist eine präzise Übereinstimmung zwischen der Laserfrequenz des Senders und der des Empfängers erforderlich. Durch beispielsweise Reflexion von Licht an Diskontinuitäten im optischen Kanal kann jedoch das über den optischen Kanal übertragene Signal teilweise überlagert werden, was zu einer verschlechterten Detektion des Signals am Empfänger führt.

Aufgabe der Erfindung ist es daher, diesbezüglich Abhilfe zu schaffen und eine Anordnung und ein Verfahren zur Verfügung zu stellen, die ein Übersprechen des Empfangssignals beispielsweise bedingt durch Diskontinuitäten im optischen Kanal minimieren.

Die Erfindung löst diese Aufgabe mit einer Anordnung zur Datenübertragung umfassend einen Sender und einen mit dem Sender über einen optischen Kanal verbundenen Empfänger gemäß Patentanspruch 1. Erfindungsgemäß ist dabei vorgesehen, dass
- der Sender einen Senderlaser und einen dem Senderlaser nachgeschalteten senderseitigen Elektroabsorptionsmodulator umfasst,
   wobei der optische Ausgang des senderseitigen Elektroabsorptionsmodulators den Ausgang des Senders bildet und an den optischen Kanal angekoppelt ist, und wobei der Sender einen elektrischen Dateneingang aufweist, der an den elektrischen Modulationsanschluss des senderseitigen Elektroabsorptionsmodulators angeschlossen ist,
- der Empfänger einen Empfängerlaser und einen dem Empfängerlaser nachgeschalteten empfängerseitigen Elektroabsorptionsmodulator umfasst,
   wobei der optische Ausgang des empfängerseitigen Elektroabsorptionsmodulators den Eingang des Empfängers bildet und an den optischen Kanal angekoppelt ist, und
   wobei der Empfänger einen elektrischen Datenausgang aufweist, der an den elektrischen Modulationsanschluss des empfängerseitigen Elektroabsorptionsmodulators angeschlossen ist,
- der Senderlaser und der Empfängerlaser durch Vorgabe einer physikalischen Größe, insbesondere durch Vorgabe des Laserstroms oder der Lasertemperatur, verstimmbar sind,
- eine senderseitige Steuereinheit und eine empfängerseitige Steuereinheit vorgesehen sind, die die jeweilige physikalische Größe zur Verstimmung des jeweiligen Lasers vorgeben,
- die senderseitige Steuereinheit und die empfängerseitige Steuereinheit miteinander synchronisiert sind, und
- die senderseitige Steuereinheit und die empfängerseitige Steuereinheit an ihrem Ausgang jeweils dasselbe Signal zur Festlegung der physikalischen Größe zur Festlegung der Laserfrequenz vorgeben.

Die Erfindung betrifft weiters ein Verfahren zur Datenübertragung zwischen einem Sender und einem mit dem Sender über einen optischen Kanal verbundenen Empfänger. Erfindungsgemäß ist dabei vorgesehen, dass
- der Sender einen Senderlaser und einen dem Senderlaser nachgeschalteten senderseitigen Elektroabsorptionsmodulator umfasst, wobei der optische Ausgang des senderseitigen Elektroabsorptionsmodulators den Ausgang des Senders bildet und an den optischen Kanal angekoppelt ist, und wobei der Sender einen elektrischen Dateneingang aufweist, der an den elektrischen Modulationsanschluss des senderseitigen Elektroabsorptionsmodulators angeschlossen ist,
- wobei der Empfänger einen Empfängerlaser und einen dem Empfängerlaser nachgeschalteten empfängerseitigen Elektroabsorptionsmodulator umfasst, wobei der optische Ausgang des empfängerseitigen Elektroabsorptionsmodulators den Eingang des Empfängers bildet und an den optischen Kanal angekoppelt ist, und wobei der Empfänger einen elektrischen Datenausgang aufweist, der an den elektrischen Modulationsanschluss des empfängerseitigen Elektroabsorptionsmodulators angeschlossen ist,
- wobei der Senderlaser und der Empfängerlaser durch Vorgabe einer physikalischen Größe, insbesondere durch Vorgabe des Laserstroms oder der Lasertemperatur, verstimmt werden,
- wobei die jeweilige physikalische Größe zur Verstimmung des jeweiligen Lasers von einer senderseitigen Steuereinheit und einer empfängerseitige Steuereinheit vorgegeben wird, und
- wobei die senderseitige Steuereinheit und die empfängerseitige Steuereinheit miteinander synchronisiert sind und
- wobei von der senderseitigen Steuereinheit und der empfängerseitigen Steuereinheit an deren jeweiligem Ausgang jeweils dasselbe Signal zur Festlegung der physikalischen Größe zur Festlegung der Laserfrequenz vorgeben wird.

Eine derartige Ausgestaltung einer Anordnung und eines Verfahrens zur Datenübertragung stellt vorteilhafterweise sicher, dass durch Vorgabe einer physikalischen Größe, beispielsweise des Laserstroms oder der Lasertemperatur, der Senderlaser und der Empfängerlaser verstimmt werden können, sodass ein Injection Locking des Senderlasers und des Empfängerlasers stattfindet, und aufgrund der präzise übereinstimmenden Laserfrequenzen ein kohärenter homodyner Empfang möglich ist.

Die Möglichkeit einer synchronen Vorgabe der Laserfrequenzen des Sender- und Empfängerlasers ermöglicht vorteilhafterweise auch, dass im Fall, dass z.B. Diskontinuitäten im optischen Kanal vorhanden sind, die zu Reflexionen von Licht führen, die Laserfrequenzen darauf abgestimmt werden können und ein Übersprechen des jeweiligen optischen Empfangssignals nahezu gänzlich verhindert wird.

Im Fall, dass Diskontinuitäten im optischen Kanal zu einer Überlagerung bzw. einem Übersprechen des am Empfänger einlangenden Signals führen, kann vorgesehen sein,
- dass die Position einer Diskontinuität oder einer Quelle von optischem Feedback, insbesondere von Reflexionen, im optischen Kanal, sowie die Lichtlaufzeit, die das Signal vom Empfängerlaser zur Diskontinuität und wieder zurück zum Empfängerlaser benötigt, festgestellt werden, und
- dass ein Signalverlauf sowie der aus dem Signalverlauf resultierende optische Frequenzverlauf des Empfängerlasers derart festgelegt werden, dass diejenigen Zeitbereiche des Übersprechens, in denen die Differenz zwischen dem Frequenzverlauf und dem um die Lichtlaufzeit verschobenen optischen Frequenzverlauf die zu übertragende optische Bandbreite des zu übertragenden elektrischen Signals unterschreitet, minimal sind.

Bei einer derartigen Vorgehensweise wird vorteilhafterweise die optische Frequenz des Empfängerlasers und Senderlasers derart festgelegt, dass sie angepasst an die Distanz L zwischen dem Empfängerlaser und der Diskontinuität verstimmt wird, sodass auf diese Weise die Verstimmung an der Round-Trip-Time, d.h. derjenigen Laufzeit, die das vom Empfängerlaser abgegebene Licht bis zur Diskontinuität und zurück zum Empfängerlaser benötigt, maximal wird und derart das Übersprechen aus der Bandbreite des am Empfänger einlangenden optischen Signals verschoben wird.

Eine weitere Verbesserung des am Empfänger einlangenden Signals im Fall von im optischen Kanal auftretenden Diskontinuitäten kann erzielt werden, wenn ein sägezahnförmiger Signalverlauf festgelegt wird, dessen Periodendauer T_{per,optimal} anhand der Lichtlaufzeit gewählt wird,
wobei insbesondere vorgesehen ist, dass für einen kohärenten homodynen Empfang als Sägezahnfrequenz die niedrigste mögliche Frequenz von fₒₚₜᵢₘₐₗ = c/2L herangezogen wird, wobei c die Lichtgeschwindigkeit im optischen Kanal angibt und L die Distanz zwischen dem Empfängerlaser und der Diskontinuität ist, sodass die Periodendauer T_{per,optimal} = 2L/c ist.

Durch eine derartige Wahl des Signalverlaufs wird besonders effektiv sichergestellt, dass derjenige Zeitraum, in dem ein, durch Reflexionen an einer Diskontinuität bedingtes, Übersprechen des vom Sender abgegebenen optischen Signals unvermeidlich in das Spektrum des am Empfänger einlangenden optischen Empfangssignals fällt, minimal ist.

Um im Fall, dass Diskontinuitäten im optischen Kanal auftreten, einen Datenverlust während der Datenübertragung besonders effektiv zu verhindern, kann vorgesehen sein, dass während der derart festgelegten Zeitbereiche des Übersprechens keine Daten übertragen werden.

Eine Möglichkeit zur abhörsicheren Datenübertragung zwischen dem Sender und dem Empfänger kann bereitgestellt werden, wenn zur abhörsicheren Datenübertragung zwischen dem Sender und dem Empfänger
- ein Schlüssel zwischen der senderseitigen Steuereinheiten und der empfängerseitigen Steuereinheit ausgetauscht wird,
- identische Signalverläufe aus dem ausgetauschten Schlüssel in der senderseitigen Steuereinheiten und der empfängerseitigen Steuereinheit abgeleitet werden, und
- die Signalverläufe dem Senderlaser und dem Empfängerlaser während der Datenübertragung zugeführt werden.

Eine Möglichkeit, Datenverluste bei einer, insbesondere abhörsicheren, Datenübertragung zwischen dem Sender und dem Empfänger zu vermeiden, kann bereitgestellt werden, wenn
- vom Empfängerlaser in einem vorgegebenen Betriebs-Frequenzbandbereich auf eine vorgegebene Weise, insbesondere mit einem sägezahnförmigen Signalverlauf, über die Zeit Licht in Frequenzen von der unteren zur oberen Grenze des Betriebs-Frequenzbandbereichs abgeben wird,
- untersucht wird, ob Licht in einer oder mehreren Frequenzen innerhalb des Betriebs-Frequenzbandbereichs über den optischen Kanal auf den empfängerseitigen Elektroabsorptionsmodulator einstrahlt und
- für die Datenübertragung zwischen dem Sender und dem Empfänger zumindest ein Frequenzband innerhalb des Betriebs-Frequenzbandbereichs gewählt wird, innerhalb dessen kein Licht auf den empfängerseitigen Elektroabsorptionsmodulator einstrahlt.

Weitere Vorteile und Ausgestaltungen der Erfindung ergeben sich aus der Beschreibung und den beiliegenden Zeichnungen.

Die Erfindung ist im Folgenden anhand von besonders vorteilhaften, aber nicht einschränkend zu verstehenden Ausführungsbeispielen in den Zeichnungen schematisch dargestellt und wird unter Bezugnahme auf die Zeichnungen beispielhaft beschrieben.

Im Folgenden zeigen schematisch:
Fig. 1 ein Ausführungsbeispiel einer erfindungsgemäßen Anordnung zur Datenübertragung,
Fig. 2 ein Beispiel für einen sägezahnförmigen Signalverlauf mit einer Periodendauer Tₚₑᵣⱼ,ₒₚₜᵢₘₐₗ,
Fig. 3 eine Detailansicht des sägezahnförmigen Signalverlaufs.

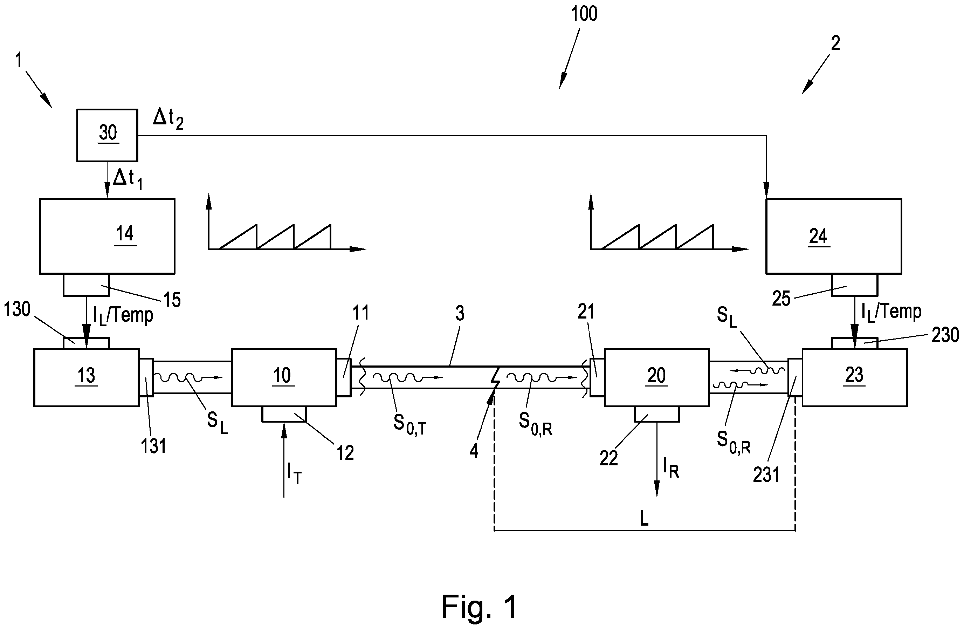

In **Fig. 1** ist ein Ausführungsbeispiel einer erfindungsgemäßen Anordnung 100 zur Datenübertragung dargestellt. Die Anordnung 100 umfasst einen Sender 1 und einen Empfänger 2, die über einen optischen Kanal 3, beispielsweise ein Glasfaserkabel, miteinander verbunden sind. Der Sender 1 umfasst dabei einen Senderlaser 13 und einen dem Senderlaser 13 nachgeschalteten senderseitigen Elektroabsorptionsmodulator 10. Der senderseitige Elektroabsorptionsmodulator 10 weist einen optischen Ausgang 11 auf, der den Ausgang des Senders 1 bildet und an den optischen Kanal 3 angekoppelt ist, sowie einen elektrischen Modulationsanschluss 12. Der elektrische Dateneingang des Senders 1 ist dabei an den elektrischen Modulationsanschluss 12 des senderseitigen Elektroabsorptionsmodulators 10 angeschlossen.

Der Empfänger 2 der Anordnung 100 umfasst einen Empfängerlaser 23 und einen dem Empfängerlaser 23 nachgeschalteten empfängerseitigen Elektroabsorptionsmodulator 20. Der optische Ausgang 21 des empfängerseitigen Elektroabsorptionsmodulators 20 bildet den Eingang des Empfängers 2 und ist an den optischen Kanal 3 angekoppelt. Der Empfänger 2 weist weiters einen elektrischen Datenausgang auf, der an den elektrischen Modulationsanschluss 22 des empfängerseitigen Elektroabsorptionsmodulators 20 angeschlossen ist.

Elektroabsorptionsmodulatoren, wie der in **Fig. 1** dargestellten Elektroabsorptionsmodulator 10, 20, sind aus dem Stand der Technik bekannt und beispielsweise in T. Ido et al., IEEE Phot. Tech. Lett., Vol. 6, no. 10, pp. 1207-1209 (1994*)* beschrieben. Derartige Elektroabsorptionsmodulatoren 10, 20 können zusammen mit Laserelementen wie dem Senderlaser 13 oder dem Empfängerlaser 23 auf einem Chip co-integriert werden.

Die Elektroabsorptionsmodulatoren 10, 20 haben die Eigenschaft, dass bei ihnen vom jeweiligen Laser 13, 23 eintretendes Licht S_{L}, abhängig von der am jeweiligen elektrischen Modulationsanschluss 12, 22 des sender- oder empfängerseitigen Elektroabsorptionsmodulators 10, 20 anliegenden Spannung, abgeschwächt wird und als ausgehendes bzw. eingehendes, optisches Signal S_{o,T}, S_{o,R} über einen optischen Anschluss 11, 21 abgegeben bzw. empfangen und in den optischen Kanal 3, z. B. einen Lichtwellenleiter wie ein Glasfaserkabel, ein- bzw. ausgekoppelt wird. Alternativ dazu kann der optische Kanal 3 auch als Freistrecke ausgebildet sein.

Der durch den elektrischen Modulationsanschluss 12, 22 des Elektroabsorptionsmodulators 10, 20 fließende elektrische Strom I_{R}, I_{T} ist dabei etwa proportional zu derjenigen Lichtmenge, die aus dem vom jeweiligen Laser 13, 23 abgegebenen Licht S_{L} entnommen und nicht in das übertragene, optische Signal S_{o,T}, S_{o,R} weitergeleitet wird.

Die Frequenz f_{L} des Lichts S_{L} wird im vorliegenden Ausführungsbeispiel innerhalb eines optischen Frequenzbereichs F von typisch ±0,1 ... 1 GHz um die optische Frequenz f_{R} des empfangenen, optischen Signals S_{o,R} vorgegeben. Ebenso kann die Frequenz f_{L} des Lichts S_{L} des jeweiligen Lasers 13, 23 auch derart eingestellt werden, dass sie innerhalb eines optischen Frequenzbereichs F von typisch ±0,1 ... 1 GHz um eine vorgegebene optische Frequenz liegt, die für das Versenden des optischen Empfangssignals S_{o,R} vorgegeben ist.

Dadurch, dass auf den Empfängerlaser 23 das Empfangssignal S_{o,R} einstrahlt, das annähernd dieselbe Frequenz hat, wie das vom Empfängerlaser 23 abgegebene Licht S_{L}, kommt es zu einem Injection Locking, bei dem sich die Frequenz des vom ("Slave"-)Laser abgestrahlten Lichts S_{L} an die optische ("Master"-)Frequenz des empfangenen, optischen Signals S_{o,R} angleicht. Die kohärent-optische Detektion des optischen Empfangssignals S_{o,R} erfolgt somit mit exakter Anpassung dieser Frequenzen, was dem Fall der homodynen Detektion im Elektroabsorptionsmodulator 20 entspricht.

Sind die Frequenzen des Lichts S_{L} des Senderlasers 13 und des empfangenen, optischen Empfangssignals S_{o,R} durch Injection Locking aneinander angepasst, findet eine Überlagerung statt, bei der die im empfangenen, optischen Empfangssignal S_{o,R} enthaltenen Signale exakt im Basisband zu liegen kommen ("homodyne Detektion"). Diese Signale sind daher besonders leicht, also ohne zusätzliche digitale Signalverarbeitung zwecks Frequenzoffsetkorrektur, auszulesen und im elektrischen Empfangssignal I_{R} besonders einfach zu identifizieren.

Der Senderlaser 13 und der Empfängerlaser 23 sind im gezeigten Ausführungsbeispiel durch Vorgabe einer physikalischen Größe verstimmbar. Dabei kann es sich beispielsweise um den Laserstrom I_{L} oder die Lasertemperatur Temp handeln. Die Abhängigkeit des vom Laser 13, 23 abgegebenen Lichts S_{L} von der Temperatur Temp des Lasers 13, 23 kann dazu genutzt werden, die Frequenz des Lichts S_{L} grob festzulegen. Die Feinsteuerung der Frequenz des Lichts S_{L} kann durch Variation des Laserstroms I_{L} vorgenommen werden.

Eine senderseitige Steuereinheit 14 und eine empfängerseitige Steuereinheit 24 der Anordnung 100 sind im Ausführungsbeispiel in **Fig. 1** an den elektrischen Eingang 130, 230 des Senderlasers 13 bzw. des Empfängerlasers 23 angeschlossen und geben die jeweilige physikalische Größe zur Verstimmung des jeweiligen Lasers 13, 23 vor. Über den elektrischen Eingang 130, 230 kann jeweils der bei der Erstellung des Lichts S_{L} verwendete Laserstrom I_{L} geregelt werden. Durch die Vorgabe des Laserstroms I_{L} kann die Wellenlänge bzw. Frequenz des vom Senderlaser 13 bzw. Empfängerlaser 23 abgegebenen Lichts S_{L}, wie zuvor beschrieben, festgelegt werden.

Weiters weisen der Senderlaser 13 und der Empfängerlaser 23 jeweils einen optischen Laserausgang 131, 231 auf, von dem aus das vom Laser 13, 23 erzeugte Licht S_{L} abgestrahlt wird.

Weiters umfasst die Anordnung 100 eine Synchronisierungseinheit 30, die an die senderseitige Steuereinheit 14 und die empfängerseitige Steuereinheit 24 angeschlossen ist und diese miteinander synchronisiert. Durch diese Synchronisation geben die senderseitige Steuereinheit 14 und die empfängerseitige Steuereinheit 24 an ihrem Ausgang 15, 25 jeweils das an die Übertragungsdistanz angepasste, selbe Signal zur Vorgabe der physikalischen Größe zur Festlegung der Laserfrequenz vor. Dies bedeutet, dass der Beginn des Frequenzverlaufs am Senderlaser 13 mit dem Beginn des Frequenzverlaufs am Empfängerlaser 23 synchronisiert ist. Das Signal wird jedoch zuvor über die Distanz zwischen dem Sender 1 und dem Empfänger 2 übertragen, sodass der Frequenzverlauf am Sender 1 geringfügig früher, beispielsweise um die Lichtlaufzeit zwischen dem Sender 1 und dem Empfänger 2 versetzt, startet, sodass eine Synchronisierung mit dem Frequenzverlauf am Empfänger 2 sichergestellt ist.

Durch die Überlagerung des Lichts S_{L} des Empfängerlasers 23 sowie des empfangenen, optischen Empfangssignals S_{o,R} wird ein Stromsignal I_{R} erstellt, das etwa proportional zum Produkt der Feldstärken des Lichts S_{L} und des Empfangssignals S_{o,R} ist. Aufgrund der Angleichung der Frequenz f_{L} des Empfängerlasers 23 an die Zentralfrequenz f_{R} des Empfangssignals S_{o,R} wird das vom Empfangssignal S_{o,R} erstellte Frequenzband in einen Frequenzbereich um 0 Hz abgebildet und landet daher im elektrischen Basisband.

Die optischen Frequenzen liegen vorteilhafterweise im Bereich von 150-800 THz. Die Bandbreite des im optischen Signal S_{o,T} modulierten Signals kann - abhängig von der Anzahl der parallel gewählten optischen Trägerfrequenzen f_{L} - etwa im Bereich von einigen GHz gewählt werden, aber in Zusammenhang mit breitbandigen Informationssignalen bis in den Bereich von typischerweise 100 GHz reichen.

In Fig. 1 liegt das elektrische Empfangssignal I_{R} am elektrischen Modulationsanschluss 22 des Empfängers 2 in Form eines Stromsignals an. Dieses Stromsignal I_{R} ist proportional zu der im Elektroabsorptionsmodulator 2 vorherrschenden Lichtleistung oder Lichtintensität. Da die Frequenz des vom Empfängerlaser 23 abgegebenen Lichts S_{L} ungefähr auf jene des optischen Empfangssignals S_{o,R} eingestellt ist und die Differenz der Frequenzen kleiner als die elektro-optische Bandbreite des Elektroabsorptionsmodulators 20 ist, ergibt sich kohärent-optische Detektion des optischen Empfangssignals S_{o,R}. Dies führt zu den im Allgemeinen bekannten Vorteilen einer höheren Detektions-Empfindlichkeit und Frequenzselektivität, d.h. es findet eine Signalfilterung während der Detektion statt.

Zum Versenden von optischen Signalen S_{o,T} mittels eines in **Fig. 1** dargestellten Elektroabsorptionsmodulators 10 wird ein Sendesignal S_{T} vorgegeben, das als elektrisches Spannungssignal I_{T} an den betreffenden elektrischen Modulationsanschluss 12 des Elektroabsorptionsmodulators 10 weitergeleitet wird.

Wie in **Fig. 1** schematisch angedeutet ist, weist der optische Kanal 3 eine Diskontinuität 4 bzw. eine Quelle von optischem Feedback auf. Durch derartige Diskontinuitäten 4 im optischen Kanal 3 wird vom Empfängerlaser 23 abgegebenes Licht S_{L} teilweise in Richtung des Empfängers 2 bzw. des Empfängerlasers 23 reflektiert und es kommt zu einer teilweisen Überlagerung bzw. einem Übersprechen auf das vom Sender 1 ausgehenden optischen Sendesignals S_{o,T}. D.h., dieses Übersprechen des optischen Sendesignals S_{o,T}, d.h. das Übersprechen durch ein gleichzeitig ausgesandtes Signal des Empfängerlasers 23, fällt in die Bandbreite des am Empfänger 2 einlangenden optischen Empfangssignals S_{o,R}, sodass die darin codierten Daten am Empfänger 2 nur mit verminderter Qualität empfangen und ausgelesen werden können.

Um dies zu vermeiden, wird bei einem erfindungsgemäßen Verfahren vorteilhafterweise die Frequenz des vom Empfängerlaser 23 ausgehenden Lichts S_{L} derart verschoben, dass am Empfänger 2 der spektrale Abstand zwischen dem vom senderseitigen Elektroabsorptionsmodulator 10 ausgehenden optischen Signals S_{o,T} und dem dazu zeitversetzt auftretenden Übersprechen maximal ist. Dazu wird die Position der Diskontinuität 4 bzw. der Quelle von optischem Feedback im optischen Kanal 3 sowie die Lichtlaufzeit, die das vom Empfängerlaser 23 abgegebene Licht S_{L} bis zur Diskontinuität 4 und wieder zurück zum Empfängerlaser 23 benötigt, festgestellt.

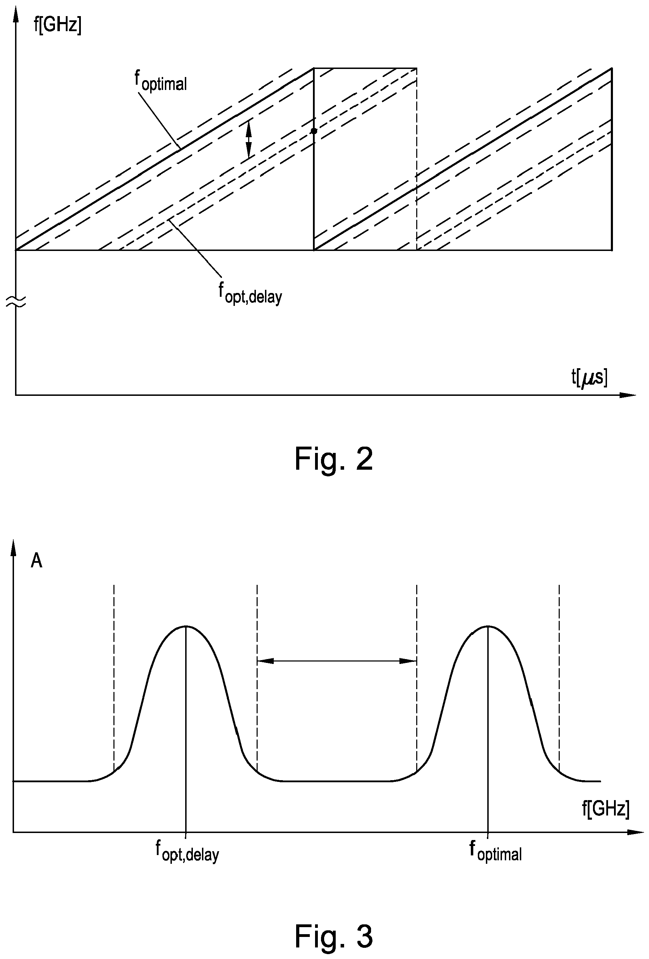

Der Signalverlauf bzw. der aus diesem Signalverlauf resultierende optische Frequenzverlauf des Empfängerlasers 23 werden anschließend an die Distanz L zwischen der Diskontinuität 4 und dem Empfängerlaser 23 angepasst. Durch diese Festlegung des Signalverlaufs bzw. des optischen Frequenzverlaufs können diejenigen Zeitbereiche des Übersprechens, in denen die Differenz zwischen dem Frequenzverlauf und dem, um die Lichtlaufzeit verschobenen, optischen Frequenzverlauf die zu übertragende optische Bandbreite des zu übertragenden elektrischen Signals I_{T} unterschreitet, minimiert werden (siehe Fig. 2).

Ein derartiger optischer Frequenzverlauf ist in **Fig. 2** dargestellt. Wie in **Fig. 2** ersichtlich ist, wird durch die Anpassung des Signalverlaufs bzw. des Frequenzverlaufs an die Distanz zwischen dem Empfängerlaser 23 und der Diskontinuität 4 die Verstimmung zu demjenigen Zeitpunkt maximiert, an dem das von der Diskontinuität 4 reflektierte Licht S_{L} wieder am Empfängerlaser 23 eintrifft, sodass das Übersprechen aus der Bandbreite des am Empfänger 2 einlangenden optischen Empfangssignals S_{o,R} verschoben ist, wie dies im Empfangsspektrum in **Fig. 3** ersichtlich ist.

Wie in **Fig. 2** ersichtlich ist, wird im Ausführungsbeispiel ein sägezahnförmiger Signalverlauf festgelegt, dessen Periodendauer T_{per,optimal} anhand der Lichtlaufzeit gewählt wird. Dabei kann beispielsweise als Sägezahnfrequenz die niedrigste mögliche Frequenz von fₒₚₜᵢₘₐₗ = c/2L herangezogen werden. Dabei ist c die Lichtgeschwindigkeit im optischen Kanal 3 und L die Distanz zwischen dem Empfänger 2 und der Diskontinuität 4, sodass sich als Periodendauer von T_{per,optimal} = 2L/c ergibt.

Wenn beispielsweise der Frequenzverlauf bzw. der Wellenlängenverlauf des Empfängerlasers 23 einem sägezahnförmigen Verlauf folgt, mit einer optischen Emissionsfrequenz von v_{S}(t) = tΔF/T_{per,optimal} wobei ΔF die maximale Abweichung der optischen Emissionsfrequenz und T_{per,optimal} die Periode des Verlaufs sind, so zeigt das durch die Reflexion an der Diskontinuität 4 im optischen Kanal 3 bedingte Übersprechen denselben Verlauf verzögert mit einer optischen Frequenz v_{R}(t) = v_{S}(t+Δt). Die Verzögerung Δt wird von der Distanz L zwischen dem Elektroabsorptionsmodulator 20 und der Diskontinuität 4 bestimmt, die mit einer Round-Trip-Time von Δt = 2L/c einhergeht.

Der spektrale Versatz bzw. der Hub ΔV des Übersprechens ist festgelegt durch die Differenz der optischen Frequenzen, die am Empfänger 2 bzw. dem Elektroabsorptionsmodulator 20 einlangen: ΔV(t) = v_{R}(t) - v_{S}(t) = 2LΔF/cT_{per,optimal}

Der optimale Frequenzverlauf ergibt sich daher, wenn der Versatz konstant und maximal bei ΔF ist. Dies ist der Fall für fₒₚₜᵢₘₐₗ = 1/T_{per,optimal} = c/2L, was, wie zuvor bereits erwähnt, die niedrigst mögliche Frequenz ist, die auch im Fall von Übersprechen einen optimalen Empfang des optischen Sendesignals S_{o,T} am Empfänger 2 sicherstellt.

Als Signalverlauf wird im Ausführungsbeispiel vorteilhafterweise eine Sägezahnfunktion gewählt, deren Flanke einen unendlich steilen Abfall aufweist. Im Bereich der Flanke des Frequenzverlaufs kann eine Überlappung des optischen Sendesignals S_{o,T} mit dem von der Diskontinuität 4 reflektierten Licht nicht vermieden werden. Durch die Wahl einer derartigen asymmetrischen Dreiecksfunktion wird diese Überlappung jedoch minimiert.

Optional kann ein Datenverlust völlig vermieden werden, wenn während der derart festgelegten Zeitbereiche des Übersprechens keine Daten vom Sender 1 an den Empfänger 2 übertragen werden.

Da die Laserfrequenz f_{L} des Senderlasers 13 und des Empfängerlasers 23 jeweils auf die gleiche Weise vorgegeben werden, kann auch in diesem Fall eine kohärente homodyne Detektion erfolgen. Ein stabiles Injection Locking der Laser 13, 23 wird im gezeigten Ausführungsbeispiel dadurch sichergestellt, dass die maximale spektrale Versatz des reflektierten Signals viel größer als der für das Injection Locking verwendete Frequenzbereich von typischerweise etwa 100 MHz ist. Der spektrale Versatz ist gemäß den Modulationsparametern typischerweise >2 GHz und kann weit darüber hinaus gehen.

Optional kann die Datenübertragung zwischen dem Sender 1 und dem Empfänger 2 abhörsicher gestaltet werden, wenn ein Schlüssel zwischen der senderseitigen Steuereinheit 14 und der empfängerseitigen Steuereinheit 24 ausgetauscht wird. Anhand des ausgetauschten Schlüssels werden identische Signalverläufe bzw. Frequenzverläufe in der senderseitigen Steuereinheit 14 und der empfängerseitigen Steuereinheit 24 abgeleitet und an den Senderlaser 13 bzw. den Empfangslaser 23 während der Datenübertragung übermittelt. Auch in diesem Fall erfolgt eine Synchronisierung der Steuereinheiten 14, 24.

Vorteilhafterweise kann zuvor die Verstimmbarkeit des Empfängers 2 ausgenutzt werden, um zuerst das Signalspektrum abzuscannen, damit bei dem oben beschriebenen "Hüpfen" des Frequenzverlaufs ein Springen auf existierende Kanäle vermieden wird. Dazu wird zunächst der gesamte Frequenzbereich kontinuierlich durchgescannt, etwa durch einen sägezahnförmigen Signalverlauf über den gesamten Ansteuerbereich des Senderlasers 13 bzw. des Empfängerlasers 23, um vorhandene Kanäle zu identifizieren und in den erstellten identischen Signalverläufen auszumaskieren.

Im Ausführungsbeispiel wird zwar zwischen einem Sender 1 und einem Empfänger 2 unterschieden und ein optisches Signal S_{o,T} vom Sender 1 an den Empfänger 2 abgegeben. Wenn es sich um eine derartige, in Fig. 1 dargestellte, unidirektionale Verbindung handelt, entsteht das Übersprechen aus dem Lasersignal S_{L} des lokalen Oszillators, bzw. des Empfängerlasers 23, welches vom Empfänger 2 mit ausgesendet wird. Der Sender 1 und der Empfänger 2 sind jedoch baugleich ausgestaltet, sodass ein optisches Signal S_{o,T} auch vom Empfänger 2 an den Sender 1 übermittelt werden kann.

Die Elektroabsorptionsmodulatoren 10, 20 können jedoch auch bidirektional betrieben werden, d.h. der Empfänger 2 kann auch gleichzeitig senden bzw. der Sender 1 kann auch gleichzeitig empfangen. Dies ist beispielsweise in B. Schrenk et al., "A Coherent Homodyne TO-Can Transceiver as Simple as an EML", IEEE/OSA J. Lightwave Technol., vol. 37, no. 2, pp. 555-561, Jan. 2019 beschrieben. In diesem Fall entsteht das Übersprechen aus dem Sendesignal, das vom Empfänger 2 gleichzeitig ausgesendet wird. Der in Fig. 1 dargestellte Sender 1 bzw. Empfänger 2 kann also jeweils gleichzeitig als Sender und Empfänger fungieren.

Für jede Diskontinuität 4 im optischen Kanal 3 ergibt sich nicht nur eine mögliche Frequenz für die Verstimmungssequenz, sondern mehrere. Praktisch wird vorzugsweise die kleinste Frequenz fₒₚₜᵢₘₐₗ gewählt. Für unterschiedliche Distanzen zwischen Elektroabsorptionsmodulator 10, 20 und Diskontinuität 4 ergeben sich unterschiedliche optimale Frequenzen fₒₚₜᵢₘₐₗ. Da es nun auch mehrere mögliche Frequenzen für die Verstimmungssequenz gibt, fallen diese auch irgendwann zusammen wobei diese "gemeinsame" Frequenz gewählt wird. Es existieren also mehrere mögliche Frequenzbänder für eine jeweilige Verstimmungssequenz, von welchen man den Überlapp, d.h. eine gemeinsame Frequenz wählt.

Wird der Hub ΔV der Verstimmung groß gewählt, ergibt sich auch eine größere Distanz zwischen den in Fig. 2 und Fig. 3 strichliert dargestellten Linien von fₒₚₜᵢₘₐₗ und f_{opt,delay}. Um eine optimale Frequenz fₒₚₜᵢₘₐₗ herum kann die tatsächlich eingesetzte Frequenz variieren, wobei der Hub ΔV der Verstimmung variiert. Bei beispielsweise sehr breiten Frequenzbändern für eine mögliche Frequenz, ergeben sich für verschiedene Entfernungen zu einer Diskontinuität 4 auch mehrere mögliche gemeinsame Frequenzen. Dies bedeutet, dass die Verstimmung ΔV bei mehreren Diskontinuitäten 4 im optischen Kanal 3 größer gewählt werden kann, um die Existenz gemeinsamer Frequenzen zu forcieren.

## Patentansprüche

1. Anordnung (100) zur Datenübertragung umfassend einen Sender (1) und einen mit dem Sender (1) über einen optischen Kanal (3) verbundenen Empfänger (2),
- wobei der Sender (1) einen Senderlaser (13) und einen dem Senderlaser (13) nachgeschalteten senderseitigen Elektroabsorptionsmodulator (10) umfasst,
wobei der optische Ausgang (11) des senderseitigen Elektroabsorptionsmodulators (10) den Ausgang des Senders (1) bildet und an den optischen Kanal (3) angekoppelt ist, und
wobei der Sender (1) einen elektrischen Dateneingang aufweist, der an den elektrischen Modulationsanschluss (12) des senderseitigen Elektroabsorptionsmodulators (10) angeschlossen ist,
- wobei der Empfänger (2) einen Empfängerlaser (23) und einen dem Empfängerlaser (23) nachgeschalteten empfängerseitigen Elektroabsorptionsmodulator (20) umfasst,
wobei der optische Ausgang (21) des empfängerseitigen Elektroabsorptionsmodulators (20) den Eingang des Empfängers (2) bildet und an den optischen Kanal (3) angekoppelt ist, und
wobei der Empfänger (2) einen elektrischen Datenausgang aufweist, der an den elektrischen Modulationsanschluss (22) des empfängerseitigen Elektroabsorptionsmodulators (20) angeschlossen ist,
- wobei der Senderlaser (13) und der Empfängerlaser (23) durch Vorgabe einer physikalischen Größe, insbesondere durch Vorgabe des Laserstroms (I_{L}) oder der Lasertemperatur (Temp), verstimmbar sind,
- wobei eine senderseitige Steuereinheit (14) und eine empfängerseitige Steuereinheit (24) vorgesehen sind, die die jeweilige physikalische Größe zur Verstimmung des jeweiligen Lasers (13, 23) vorgeben,
- wobei die senderseitige Steuereinheit (14) und die empfängerseitige Steuereinheit (24) miteinander synchronisiert sind, und
- wobei die senderseitige Steuereinheit (14) und die empfängerseitige Steuereinheit (24) an ihrem Ausgang (15, 25) jeweils dasselbe Signal zur Festlegung der physikalischen Größe zur Festlegung der Laserfrequenz vorgeben.

2. Verfahren zur Datenübertragung zwischen einem Sender (1) und einem mit dem Sender (1) über einen optischen Kanal (3) verbundenen Empfänger (2),
- wobei der Sender (1) einen Senderlaser (13) und einen dem Senderlaser (13) nachgeschalteten senderseitigen Elektroabsorptionsmodulator (10) umfasst, wobei der optische Ausgang (11) des senderseitigen Elektroabsorptionsmodulators (10) den Ausgang des Senders (1) bildet und an den optischen Kanal (3) angekoppelt ist, und wobei der Sender (1) einen elektrischen Dateneingang aufweist, der an den elektrischen Modulationsanschluss (12) des senderseitigen Elektroabsorptionsmodulators (10) angeschlossen ist,
- wobei der Empfänger (2) einen Empfängerlaser (23) und einen dem Empfängerlaser (23) nachgeschalteten empfängerseitigen Elektroabsorptionsmodulator (20) umfasst, wobei der optische Ausgang (21) des empfängerseitigen Elektroabsorptionsmodulators (20) den Eingang des Empfängers (2) bildet und an den optischen Kanal (3) angekoppelt ist, und wobei der Empfänger (2) einen elektrischen Datenausgang aufweist, der an den elektrischen Modulationsanschluss (22) des empfängerseitigen Elektroabsorptionsmodulators (20) angeschlossen ist,
- wobei der Senderlaser (13) und der Empfängerlaser (23) durch Vorgabe einer physikalischen Größe, insbesondere durch Vorgabe des Laserstroms (I_{L}) oder der Lasertemperatur (Temp), verstimmt werden,
- wobei die jeweilige physikalische Größe zur Verstimmung des jeweiligen Lasers (13, 23) von einer senderseitigen Steuereinheit (14) und einer empfängerseitige Steuereinheit (24) vorgegeben wird, und
- wobei die senderseitige Steuereinheit (14) und die empfängerseitige Steuereinheit (24) miteinander synchronisiert sind und
- wobei von der senderseitigen Steuereinheit (14) und der empfängerseitigen Steuereinheit (24) an deren jeweiligem Ausgang (15, 25) jeweils dasselbe Signal zur Festlegung der physikalischen Größe zur Festlegung der Laserfrequenz vorgeben wird.

3. Verfahren nach Anspruch 2, **dadurch gekennzeichnet,**
- **dass** die Position einer Diskontinuität (4) oder einer Quelle von optischem Feedback, insbesondere von Reflexionen, im optischen Kanal, sowie die Lichtlaufzeit, die das Signal vom Empfängerlaser (23) zur Diskontinuität (4) und wieder zurück zum Empfängerlaser (23) benötigt, festgestellt werden, und
- **dass** ein Signalverlauf sowie der aus dem Signalverlauf resultierende optische Frequenzverlauf des Empfängerlasers (23) derart festgelegt werden, dass diejenigen Zeitbereiche des Übersprechens, in denen die Differenz zwischen dem Frequenzverlauf und dem um die Lichtlaufzeit verschobenen optischen Frequenzverlauf die zu übertragende optische Bandbreite des zu übertragenden elektrischen Signals unterschreitet, minimal sind.

4. Verfahren nach Anspruch 2 oder 3, **dadurch gekennzeichnet, dass** ein sägezahnförmiger Signalverlauf festgelegt wird, dessen Periodendauer (T_{per,optimal}) anhand der Lichtlaufzeit gewählt wird,
wobei insbesondere vorgesehen ist, dass für einen kohärenten homodynen Empfang als Sägezahnfrequenz die niedrigste mögliche Frequenz von fₒₚₜᵢₘₐₗ = c/2L herangezogen wird, wobei c die Lichtgeschwindigkeit im optischen Kanal (3) angibt und L die Distanz zwischen dem Empfängerlaser (23) und der Diskontinuität (4) ist, sodass die Periodendauer T_{per,optimal} = 2L/c ist.

5. Verfahren nach einem der Ansprüche 3 oder 4, **dadurch gekennzeichnet, dass** während der derart festgelegten Zeitbereiche des Übersprechens keine Daten übertragen werden.

6. Verfahren nach einem der Ansprüche 2 bis 5, **dadurch gekennzeichnet, dass** zur abhörsicheren Datenübertragung zwischen dem Sender (1) und dem Empfänger (2)
- ein Schlüssel zwischen der senderseitigen Steuereinheiten (14) und der empfängerseitigen Steuereinheit (24) ausgetauscht wird,
- identische Signalverläufe aus dem ausgetauschten Schlüssel in der senderseitigen Steuereinheiten (14) und der empfängerseitigen Steuereinheit (24) abgeleitet werden, und
- die Signalverläufe dem Senderlaser (13) und dem Empfängerlaser (23) während der Datenübertragung zugeführt werden.

7. Verfahren nach einem der Ansprüche 2 bis 6, **dadurch gekennzeichnet,**
- **dass** vom Empfängerlaser (23) in einem vorgegebenen Betriebs-Frequenzbandbereich auf eine vorgegebene Weise, insbesondere mit einem sägezahnförmigen Signalverlauf, über die Zeit Licht in Frequenzen von der unteren zur oberen Grenze des Betriebs-Frequenzbandbereichs abgeben wird,
- **dass** untersucht wird, ob Licht in einer oder mehreren Frequenzen innerhalb des Betriebs-Frequenzbandbereichs über den optischen Kanal (3) auf den empfängerseitigen Elektroabsorptionsmodulator (20) einstrahlt und
- **dass** für die Datenübertragung zwischen dem Sender (1) und dem Empfänger (2) zumindest ein Frequenzband innerhalb des Betriebs-Frequenzbandbereichs gewählt wird, innerhalb dessen kein Licht auf den empfängerseitigen Elektroabsorptionsmodulator (20) einstrahlt.
